# EUROPÄISCHE PATENTANMELDUNG

(11) **EP 2 605 280 A1**
(43) Veröffentlichungstag der Anmeldung: **19.06.2013**
(21) Anmeldenummer: 12196803.6
(22) Anmeldetag: 12.12.2012
(51) Int. Cl.: H01L 27/30, H01L 51/00, H01L 51/42, H01L 51/44, H01L 51/48

(54) **Metallisches Bauelement oder Flacherzeugnis mit photovoltaisch wirksamer Beschichtung, Verfahren zu dessen Herstellung und aus solchen, miteinander elektrisch verschalteten Bauelementen gebildete Verkleidung**

(30) Priorität: 16.12.2011 DE 102011121165
(71) Anmelder: ThyssenKrupp Steel Europe AG, 47166 Duisburg (DE)
(72) Erfinder: Schauer-Paß, Dr. Janine, 44803 Bochum (DE); Meschede, Dr. Andreas, 51465 Bergisch Gladbach (DE); Nabbefeld-Arnold, Dr. Erich, 45470 Mühlheim (DE); Hohlsiepe, Dr.-Ing. Uwe, 46569 Hünxe (DE)
(74) Vertreter: Cohausz & Florack

(57) **Zusammenfassung**

Die Erfindung betrifft ein Verfahren zur Herstellung eines metallischen Flacherzeugnisses oder Bauelements mit photovoltaisch wirksamer Beschichtung. Um ein solches Flacherzeugnis oder Bauelement kostengünstig herstellen zu können, wobei das Bauelement einen einfachen und zuverlässigen elektrischen Kontaktabgriff bieten soll, werden bei dem erfindungsgemäßen Verfahren auf ein bandförmiges Metallsubstrat (1), das mindestens einseitig mit einer mindestens teilweise elektrisch isolierenden Schicht (2) versehen ist, in kontinuierlichem Durchlauf auf die mindestens teilweise elektrisch isolierende Schicht (2) bereichsweise elektrisch leitfähige Schichten als Elektrode und Gegenelektrode mit mindestens einer dazwischen angeordneten photoaktiven Polymerschicht zur Bildung organischer Solarzellen (3) so aufgebracht, dass die Solarzellen (3) in Längsrichtung des bandförmigen Metallsubstrats (1) aufeinanderfolgend angeordnet sind. Zudem werden in Durchlaufrichtung des bandförmigen Metallsubstrates (1) elektrisch leitfähige Bänder (4) parallel zueinander verlaufend so aufgebracht, dass eines der Bänder (4) die Elektrode der Solarzellen (3) und ein anderes der Bänder (4) die Gegenelektrode der Solarzellen (3) miteinander elektrisch verbindet. Die elektrisch leitfähigen Bänder (4) werden dabei an gegenüberliegenden Rändern der Solarzellen (3) so angeordnet, dass mindestens eines der elektrisch leitfähigen Bänder (4) die Elektrode oder Gegenelektrode der Solarzellen (3) in Richtung Längskante des bandförmigen Metallsubstrats (1) überragt oder bündig mit der Elektrode oder Gegenelektrode der Solarzellen (3) abschließt.

## Beschreibung

Die Erfindung betrifft ein Verfahren zur Herstellung eines metallischen Flacherzeugnisses oder Bauelements mit photovoltaisch wirksamer Beschichtung, ein entsprechend hergestelltes metallisches Flacherzeugnis oder metallisches Bauelement sowie eine aus solchen, miteinander elektrisch verschalteten Bauelementen gebildete Verkleidung.

Im Unterschied zu anorganischen Solarzellen, bei denen Siliziumzellen als Träger für Photovoltaik-Elemente verwendet werden, sind organische Solarzellen im Wesentlichen aus Werkstoffen der organischen Chemie hergestellt, d.h. aus Kunststoffen. Das Material für organische Solarzellen basiert auf organischen Kohlenwasserstoffverbindungen mit einer speziellen Elektronenstruktur, die diesen Materialen die wesentlichen Eigenschaften amorpher Halbleiter verleiht. Typische Vertreter organischer Halbleiter sind konjugierte Polymere. Die Vorteile der organischen Photovoltaik (OPV) liegen in der Möglichkeit, die entsprechenden organischen Solarzellen als flexible Schichtsysteme, großflächig, mit geringem Gewicht und in Massenproduktion kostengünstig herstellen zu können.

Ein Verfahren zur Herstellung von organischen Solarzellen ist beispielsweise aus der WO 2010/037554 A2 bekannt.

Der vorliegenden Erfindung liegt die Aufgabe zugrunde, ein Verfahren zur Herstellung eines metallischen Flacherzeugnisses oder Bauelements mit einer photovoltaisch wirksamen Beschichtung anzugeben, das eine kostengünstige Herstellung eines solchen Flacherzeugnisses oder Bauelements ermöglicht, wobei das aus dem Flacherzeugnis hergestellte Bauelement einen einfachen und zuverlässigen elektrischen Kontaktabgriff bieten soll.

Zur Lösung dieser Aufgabe wird ein Verfahren mit den Merkmalen des Anspruchs 1 vorgeschlagen.

Bevorzugte und vorteilhafte Ausgestaltungen der Erfindung sind in den Unteransprüchen angegeben.

Bei dem erfindungsgemäßen Verfahren werden auf ein bandförmiges Metallsubstrat, vorzugsweise Stahlsubstrat, das mindestens einseitig mit einer mindestens teilweise elektrisch isolierenden Schicht versehen ist, in kontinuierlichem Durchlauf auf die mindestens teilweise elektrisch isolierende Schicht bereichsweise elektrisch leitfähige Schichten als Elektrode und Gegenelektrode mit mindestens einer dazwischen angeordneten photoaktiven Polymerschicht zur Bildung organischer Solarzellen so aufgebracht, dass die Solarzellen in Längsrichtung des bandförmigen Metallsubstrats aufeinanderfolgend angeordnet sind. Zudem werden bei dem erfindungsgemäßen Verfahren in Durchlaufrichtung des bandförmigen Metallsubstrates elektrisch leitfähige Bänder parallel zueinander verlaufend so aufgebracht, dass eines der Bänder die Elektrode der Solarzellen und ein anderes der Bänder die Gegenelektrode der Solarzellen miteinander elektrisch verbindet. Die elektrisch leitfähigen Bänder werden dabei an gegenüberliegenden Rändern der Solarzellen so angeordnet, dass mindestens eines der elektrisch leitfähigen Bänder die Elektrode oder Gegenelektrode der Solarzellen in Richtung Längskante des bandförmigen Metallsubstrats überragt oder bündig mit der Elektrode oder Gegenelektrode der Solarzellen abschließt.

Die durchgängig ausgebildeten elektrisch leitfähigen Bänder ermöglichen einen besonders einfachen und zuverlässigen elektrischen Kontaktabgriff an den einzelnen Solarzellen sowie eine einfache und zuverlässige elektrische Verbindung einer Mehrzahl solcher Solarzellen, sogenannte Module. Insbesondere ermöglichen die durchgängig ausgebildeten elektrisch leitfähigen Bänder auf einfache und zuverlässige Weise eine verdeckte elektrische Verbindung der organischen Solarzellen in Reihen- und/oder Parallelschaltung, so dass die elektrischen Kontaktabgriffe vor äußeren Witterungseinwirkungen sowie mechanischen Einwirkungen geschützt angeordnet bzw. ausgebildet sind. Bei Bedarf können weitere Leiter/Kabel vorgesehen sein, die parallel zu den elektrisch leitfähigen Bändern verschaltet werden, um die Leitfähigkeit des Systems zu erhöhen.

Zur Herstellung von metallischen Bauelementen in bestimmten Längen bzw. Größen sieht eine bevorzugte Ausgestaltung des erfindungsgemäßen Verfahrens vor, dass das bandförmige Metallsubstrat zwischen zwei der aufeinander folgenden organischen Solarzellen quergeteilt wird. Somit kann das bandförmige Flacherzeugnis mit den darauf aufgebrachten organischen Solarzellen in eine Vielzahl von jeweils eine oder mehrere Solarzellen aufweisende Platinen zur Weiterverarbeitung in profilierte oder dreidimensional strukturierte Bauelemente gewünschter Größen zugeschnitten werden. Das Querteilen des bandförmigen Metallsubstrats wird dabei vorzugsweise mittels einer in Durchlaufrichtung des bandförmigen Metallsubstrats mitbewegbaren Schneidvorrichtung nach Art einer sogenannten fliegenden Säge durchgeführt.

Aus einem erfindungsgemäß hergestellten metallischen Flacherzeugnis mit photovoltaischer Funktion bzw. den daraus gewonnenen Platinen werden vorzugsweise Dach- oder Fassadenelemente, Sichtschutz- und/oder Schallschutzwände oder Garagentore gefertigt.

Eine weitere bevorzugte Ausgestaltung des erfindungsgemäßen Verfahrens sieht vor, dass eine durch Querteilen des bandförmigen Metallsubstrats erhaltene Platine so umgeformt wird, dass dadurch mindestens eines der elektrisch leitfähigen Bänder rückseitig zu der solarzellenbeschichteten Oberseite angeordnet wird. Hierdurch wird ein von der solarzellenbeschichteten Oberseite nicht sichtbarer und durch das Metallsubstrat geschützter Kontaktabgriff ermöglicht bzw. erzielt. Aufgrund der länglichen Ausbildung und durchgängigen Erstreckung des jeweiligen elektrisch leitfähigen Bandes ergibt sich eine sehr sichere Zuordnung und Kontaktierung in Bezug auf ein elektrisches Kontaktelement, insbesondere ein Kontaktelement mit relativ kleiner elektrischer Kontaktfläche, wie beispielsweise eine Kontaktschraube oder ein Kontaktstecker, wobei beliebige Ausführungen denkbar sind.

Eine weitere vorteilhafte Ausgestaltung des erfindungsgemäßen Verfahrens ist dadurch gekennzeichnet, dass eine durch Querteilen des bandförmigen Metallsubstrats erhaltene Platine so umgeformt wird, dass eine Längskante der Platine eine Längsnut und die gegenüberliegende Längskante der Platine eine in die Längsnut einer entsprechend umgeformten Platine einsteckbare Feder bildet, und dass dadurch das eine elektrisch leitfähige Band in der Längsnut, abgewandt von der solarzellenbeschichteten Oberseite der Platine angeordnet wird, während das andere elektrisch leitfähige Band auf der Oberseite der Feder angeordnet wird. Die elektrisch leitfähigen Bänder sind dann in einer flächigen Verkleidung, beispielsweise einer Dach- oder Fassadenverkleidung, die aus Bauelementen gebildet ist, welche durch Umformen von entsprechenden Platinen hergestellt wurden und über die Nut-Feder-Verbindung miteinander verbunden sind, verdeckt angeordnet und gegen mechanische Einwirkungen, wie etwa Hagel oder abrutschende Schnee- und Eisplatten geschützt.

Günstig ist ferner, wenn nach einer weiteren bevorzugten Ausgestaltung des erfindungsgemäßen Verfahrens die auf das bandförmige Metallsubstrat aufgebrachten Solarzellen sowie die aufgebrachten elektrisch leitfähigen Bänder mit einer elektrisch isolierenden, transparenten Abdeckschicht versehen werden. Durch eine entsprechende Abdeckschicht werden die Solarzellen und die elektrisch leitfähigen Bänder vor äußeren Einwirkungen, insbesondere Witterungseinwirkungen geschützt. Zugleich werden die elektrisch leitfähigen Schichten und Bänder durch die Abdeckschicht gegenüber der Umgebung elektrisch isoliert. Zudem verfügt das mit einer Abdeckschicht versehene bandförmige Metallsubstrat über eine hohe Barrierewirkung gegenüber Wasserdampf und Luftsauerstoff, wodurch die Lebensdauer der "eingekapselten" Solarzellen erhöht werden kann.

Eine weitere bevorzugte Ausgestaltung des erfindungsgemäßen Verfahrens sieht in diesem Zusammenhang vor, dass die Abdeckschicht im Bereich der elektrisch leitfähigen Bänder partiell abgetragen wird. Hierdurch wird eine zuverlässige Kontaktierung des jeweiligen elektrisch leitfähigen Bandes durch ein daran anliegendes elektrisches Kontaktelement, beispielsweise eine Kontaktschraube oder ein Kontaktstecker sichergestellt. Alternativ können aber auch selbstschneidende elektrische Kontaktelemente verwendet werden, welche die elektrisch isolierende Abdeckschicht bei der Montage durchdringen und somit das zugeordnete elektrisch leitfähige Band elektrisch leitend kontaktieren.

Eine weitere vorteilhafte Ausgestaltung des erfindungsgemäßen Verfahrens sieht vor, dass im Bereich mindestens eines der elektrisch leitfähigen Bänder mindestens eine Durchgangsöffnung in das Metallsubstrat eingearbeitet wird. Solche Durchgangsöffnungen erleichtern die geschützte, insbesondere verdeckte Anordnung von Kontaktelementen zum elektrischen Abgriff der elektrisch leitfähigen Schichten bzw. Bänder.

Eine weitere vorteilhafte Ausgestaltung des erfindungsgemäßen Verfahrens sieht vor, dass aus dem bandförmigen Metallsubstrat durch Querteilen desselben erhaltene Platinen auf ihrer der jeweiligen Solarzelle abgewandten Rückseite jeweils mit einer wärme- und/oder schallisolierenden Schicht kaschiert bzw. geschäumt werden. Hierdurch haben die erfindungsgemäß hergestellten Platinen nicht nur eine photovoltaische Funktion, sondern erhalten zusätzlich auch noch eine wärme- und/oder schallisolierende Funktion.

Nach einer weiteren Ausgestaltung der Erfindung kann ein aus einem erfindungsgemäß hergestellten metallischen Flacherzeugnis gefertigtes Bauelement als zusätzliche Option mit einer solarthermischen Funktion verknüpft werden, so dass das Bauelement sowohl elektrischen Strom als auch Wärmeenergie liefern kann. Dementsprechend ist eine weitere vorteilhafte Ausgestaltung des erfindungsgemäßen Verfahrens dadurch gekennzeichnet, dass aus dem bandförmigen Metallsubstrat durch Querteilen desselben erhaltene Platinen auf ihrer der jeweiligen Solarzelle abgewandten Rückseite jeweils mit einem Solarthermie-Kollektor versehen werden.

Als weitere Option kann ein aus einem erfindungsgemäß hergestellten metallischen Flacherzeugnis gefertigtes Bauelement mit einer thermochromen Beschichtung versehen sein. Bei unterschiedlichen Temperaturen erscheint das Bauelement dann in unterschiedlichen Farben. Damit können wechselnde Farbwirkungen als gestalterische Elemente in einer aus entsprechenden Bauelementen zusammengesetzten Fassade erzielt werden. Dementsprechend ist eine weitere vorteilhafte Ausgestaltung des erfindungsgemäßen Verfahrens dadurch gekennzeichnet, dass als elektrisch isolierende Schicht des bandförmigen Metallsubstrats und/oder als elektrisch isolierende, transparente Abdeckschicht der Solarzellen eine thermochrome Beschichtung verwendet wird.

Für ein einfaches Handling eines erfindungsgemäß hergestellten metallischen Flacherzeugnisses ist es zweckmäßig, wenn nach einer weiteren Ausgestaltung des erfindungsgemäßen Verfahrens das bandförmige Metallsubstrat nach Aufbringen der organischen Solarzellen, der elektrisch leitfähigen Bänder und einer elektrisch isolierenden, transparenten Abdeckschicht zu einer Rolle aufgewickelt wird. Eine solche Rolle lässt sich gut transportieren sowie platzsparend zwischenlagern.

Eine andere vorteilhafte Ausgestaltung des erfindungsgemäßen Verfahrens sieht vor, dass das bandförmige Metallsubstrat nach Aufbringen der organischen Solarzellen, der elektrisch leitfähigen Bänder und einer elektrisch isolierenden, transparenten Abdeckschicht durch Rollformen umgeformt wird. Auf diese Weise lassen sich profilförmige Bauelemente mit photovoltaischer Funktion und gegebenenfalls zusätzlichen Funktionen, beispielsweise einer wärme- und/oder schallisolierenden Funktion, in einem kontinuierlichen Umformprozess kostengünstig herstellen.

Zur Herstellung einer Verkleidung, insbesondere einer Dach- oder Wandfassade, die aus nach dem erfindungsgemäßen Verfahren gefertigten metallischen Bauelementen mit photovoltaisch wirksamer Beschichtung zusammengesetzt wird, werden nach einem bevorzugten Aspekt der vorliegenden Erfindung die elektrisch leitfähigen Bänder mit elektrischen Kontaktelementen versehen, die einen elektrischen Abgriff auf der Rückseite der Verkleidung gestatten. Die elektrischen Kontaktelemente werden hierzu beispielsweise als Kontaktschrauben oder Kontaktstecker ausgeführt.

Nach einer weiteren vorteilhaften Ausgestaltung der Erfindung kann das jeweilige elektrische Kontaktelement mindestens zwei elektrische Leiter umfassen, die beispielsweise koaxial zueinander verlaufende Abschnitte aufweisen und voneinander elektrisch isoliert sind. Mittels solcher Kontaktelemente lässt sich der erforderliche elektrische Kontaktabgriff auf schnelle und kostengünstige Weise realisieren, indem beispielsweise eine einzelne Durchgangsöffnung in dem jeweiligen Bauelement zur Durchleitung mehrerer elektrischer Leiter genutzt werden kann. Insbesondere lassen sich so die Leitungen bzw. Kabel für den Plus- und Minuspol der organischen Solarzelle durch eine gemeinsame Durchgangsöffnung hindurchführen. Denkbar ist es auch, die entsprechenden Leiter nebeneinander zu führen.

Nachfolgend wird die Erfindung anhand einer mehrere Ausführungsbeispiele darstellenden Zeichnung näher erläutert. Es zeigen schematisch:
- Fig. 1: eine Draufsicht auf einen Abschnitt eines bandförmigen Metallsubstrats bzw. metallischen Flacherzeugnisses mit darauf aufgebrachten organischen Solarzellen;
- Fig. 2: eine Querschnittansicht des Flacherzeugnisses entlang der Schnittlinie II-II in Fig. 1;
- Fig. 3: eine Querschnittansicht des Flacherzeugnisses entlang der Schnittlinie III-III in Fig. 1;
- Fig. 4: eine Querschnittansicht des Flacherzeugnisses entsprechend Fig. 2, jedoch nach Aufbringen einer transparenten, elektrisch isolierenden Abdeckschicht;
- Fig. 5: eine Querschnittansicht des Flacherzeugnisses entsprechend Fig. 3, jedoch nach Aufbringen einer transparenten, elektrisch isolierenden Abdeckschicht;
- Fig. 6: einen Abschnitt eines metallischen Bauelements mit einem schraubenförmigen Kontaktelement, in Querschnittansicht;
- Fig. 7: einen Abschnitt eines weiteren schraubenförmigen Kontaktelements in Längsschnittansicht;
- Fig. 8: miteinander verbundene Abschnitte zweier metallischer Bauelemente, die jeweils organische Solarzellen aufweisen, und ein schraubenförmiges Kontaktelement zum elektrischen Abgriff der Solarzellen, in Querschnittansicht; und
- Fig. 9: einen Abschnitt eines weiteren metallischen Bauelements mit einem schraubenförmigen Kontaktelement, in Querschnittansicht.

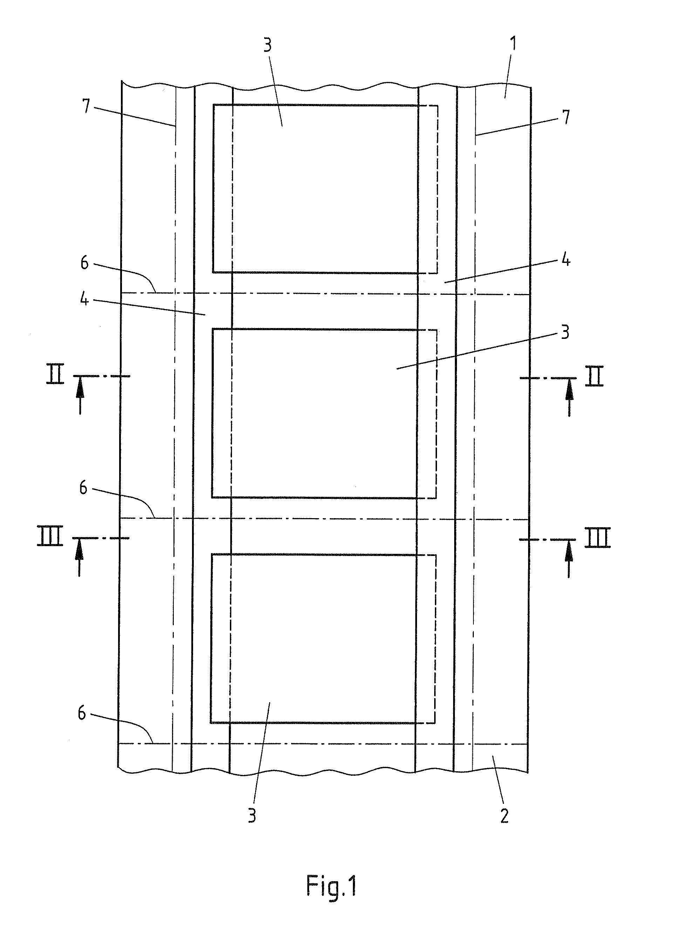

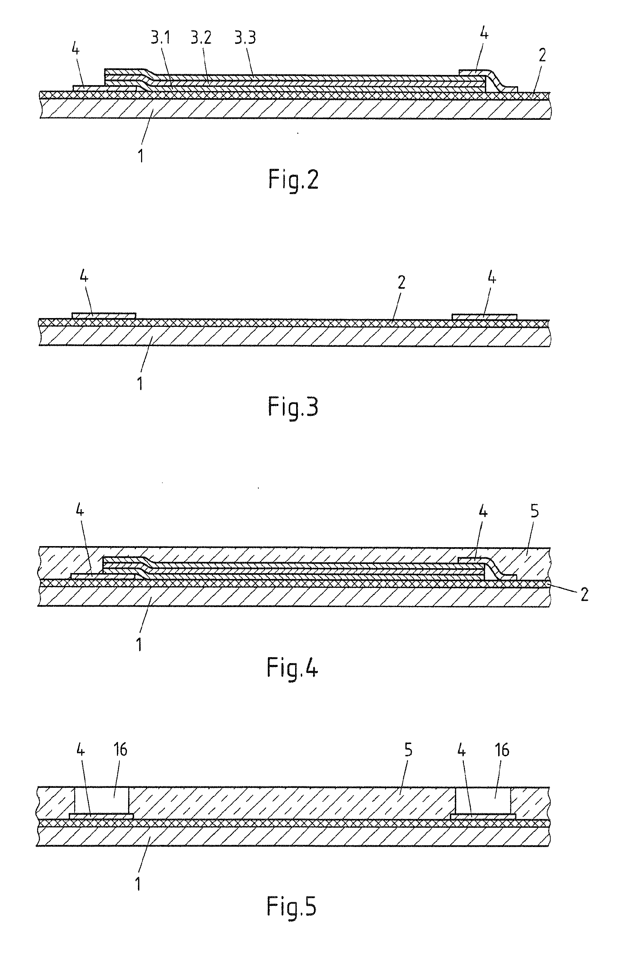

In Fig. 1 ist ein Abschnitt eines bandförmigen Metallsubstrats bzw. bandförmigen metallischen Flacherzeugnisses 1 schematisch dargestellt. Bei dem Metallsubstrat 1 handelt es sich vorzugsweise um Stahlblech. Besonders bevorzugt kann es sich bei dem Metallsubstrat 1 um ein organisch beschichtetes oder feuerveredeltes bandförmiges Metallsubstrat handeln. Die Oberseite des Metallsubstrats 1 ist mit einer elektrisch isolierenden Schicht 2, beispielsweise einer Kunststoffschicht beschichtet (vgl. Figuren 2 und 3). Die Schicht 2 bedeckt die Oberseite des Metallsubstrats 1 vorzugsweise vollflächig. Alternativ kann aber auch mindestens ein Randstreifen des Metallsubstrats 1 ohne die elektrisch isolierende Schicht 2 ausgebildet sein. Die elektrisch isolierende Schicht 2 wird vorzugsweise mittels eines kontinuierlichen Auftragsprozesses, beispielsweise mittels Auftragswalzen auf das Metallsubstrat 1 aufgebracht.

Auf die elektrisch isolierende Schicht 2 werden anschließend in kontinuierlichem Durchlauf organische Solarzellen 3 aufgebracht, und zwar so, dass die Solarzellen 3 (Module) in Längsrichtung des bandförmigen Metallsubstrats 1 aufeinanderfolgend angeordnet sind (vgl. Fig. 1). Die jeweilige Solarzelle 3 besteht aus einer ersten elektrisch leitfähigen Schicht 3.1, die als Elektrode dient, mindestens einer photoaktiven Schicht 3.2 und einer zweiten elektrisch leitfähigen Schicht 3.3, die als Gegenelektrode dient.

Die organischen Solarzellen 3 (Module) werden dabei vorzugsweise als Schichtverbund in vorkonfektionierter Form auf die isolierende Schicht 2 aufgebracht. Es liegt jedoch auch im Rahmen der Erfindung, die Schichten 3.1, 3.2, 3.3 der jeweiligen organischen Solarzelle 3 in aufeinanderfolgenden Bearbeitungsstationen aufzutragen. Die Schichten 3.1, 3.2, 3.3 der Solarzellen 3 werden dabei vorzugsweise im Druckverfahren und/oder mittels Breitschlitzdüsen kontinuierlich aufgetragen.

Vor, während und/oder nach dem Aufbringen der Solarzellen 3 werden elektrisch leitfähige Bänder (sogenannte "busbars" oder Leiterbahnen) 4 aufgebracht, und zwar so, dass die Bänder 4 in Durchlaufrichtung des bandförmigen Metallsubstrates 1 parallel zueinander verlaufen und eines der Bänder 4 die Elektrode der Solarzellen 3 und ein anderes der Bänder 4 die Gegenelektrode der Solarzellen 3 miteinander elektrisch verbindet. Hierzu werden die Schichten 3.1, 3.2, 3.3 der einzelnen Solarzellen hinsichtlich ihrer Abmessungen und/oder ihrer nicht überlappenden Bereichen auf den Verlauf und die zeitliche Anordnung der elektrisch leitfähigen Bänder (Leiterbahnen) 4 abgestimmt. Beispielsweise kann auf die isolierende Schicht 2 zunächst nur ein erstes der elektrisch leitfähigen Bänder 4 aufgebracht werden. Anschließend werden dann die Schichten 3.1, 3.2, 3.3 der organischen Solarzellen 3 so aufgebracht, dass die als Elektrode bzw. Gegenelektrode dienende elektrisch leitfähige Schicht 3.1 das (erste) elektrisch leitfähige Band 4 elektrisch kontaktiert. Danach wird dann ein zweites elektrisch leitfähiges Band 4 aufgebracht, welches die obere elektrisch leitfähige Schicht (Elektrode bzw. Gegenelektrode) 3.3 der Solarzelle 3 elektrisch kontaktiert (vgl. Fig. 2). Die elektrisch leitfähigen Bänder 4 und die Schichten 3.1, 3.2, 3.3 der jeweiligen Solarzelle 3 werden dabei relativ zueinander vorzugsweise so angeordnet, dass das jeweilige elektrisch leitfähige Band 4 mit einem Teil seiner Breite seitlich neben der jeweiligen Solarzelle 3 liegt (vgl. Fig. 2). Alternativ können die elektrisch leitfähigen Bänder 4 und die Schichten 3.1, 3.2, 3.3 der jeweiligen Solarzelle 3 aber auch so relativ zueinander angeordnet werden, dass mindestens eines der leitfähigen Bänder 4 im Wesentlichen bündig mit einem Seitenrand der Solarzelle 3 abschließt. Die einzelnen Solarzellen 3 sind über die Breite des bandförmigen Metallsubstrates 1 in Reihe verschaltet. Über die Länge können diese so entstandenen Module dann in Reihe oder vorzugsweise parallel verschaltet werden.

Nachdem die elektrisch leitfähigen Bänder 4 und die Schichten 3.1, 3.2, 3.3 der organischen Solarzellen 3 in einem kontinuierlichen Prozess auf die elektrisch isolierende Schicht 2 des bandförmigen Metallsubstrats 1 aufgebracht wurden, erfolgt eine Verkapselung durch Aufbringen einer elektrisch isolierenden Abdeckschicht 5, die transparent ausgebildet ist (vgl. Figuren 4 und 5). Als Abdeckschicht 5 wird vorzugsweise eine transparente Folie oder ein transparent aushärtender Lack verwendet. Das Aufbringen der Abdeckschicht 5 erfolgt ebenfalls vorzugsweise in einem kontinuierlichen Prozess, wobei diese neben der elektronischen Isolierung auch eine Barrierewirkung hat, vorzugsweise wenn die gesamte Solarzelle 3 gut gegen Sauerstoff und Wasserstoff "verkapselt" ist, d.h. wenn die Abdeckschicht 5 die Schichten 3.1, 3.2, 3.3 vollständig abdeckt.

Eine Querteilung des bandförmigen Flacherzeugnisses 1 ist zwischen den aufeinanderfolgenden Solarzellen 3 möglich. Die Querteilung des Flacherzeugnisses 1 kann an Soll-Schnittkanten 6 erfolgen, die in Fig. 1 durch strichpunktierte Linien markiert sind.

Die Parallelverschaltung der einzelnen Solarzellen 3 bzw. Module erfolgt mittels der elektrisch leitfähigen Bänder ("busbars") 4, die links und rechts der organischen Solarzellen 3 bzw. Module an gegenüberliegenden Rändern der Solarzellen 3 angeordnet sind.

Die Bänder ("busbars") 4 sind aus elektrisch leitfähigem Material gebildet, das vorzugsweise mittels eines Druck- oder Kaschierverfahrens auf das Metallsubstrat (Flacherzeugnis) 1 aufgedruckt bzw. aufgeklebt wird. Die elektrisch leitfähigen Bänder 4 erstrecken sich durchgängig über die gesamte Länge einer durch Querteilen des bandförmigen Metallsubstrats 1 erhaltenen Platine bzw. eines daraus durch Umformen hergestellten Bauelements. Die Breite der Bänder 4 liegt beispielsweise im Bereich von 5 mm bis 40 mm, vorzugsweise im Bereich von 15 mm bis 35 mm. Bei Bedarf können die Bänder 4 auch schmaler ausfallen.

Die leitfähigen Bänder 4 können oberseitig im nicht umzuformenden Bereich des Metallsubstrats (Flacherzeugnisses) 1 oder im später umzuformenden Kantenbereich verlaufen. Der letztgenannte Fall bietet den Vorteil, dass die leitfähigen Bänder 4 nach der Umformung auf der Rückseite des Bauelements bzw. im verdeckten Bereich des Stoßes zwischen zwei aneinander gestoßenen Bauelementen versteckt und somit vor Witterung geschützt sind. Denkbar ist es auch, Laschen oder ähnliche Verbreiterungen in regelmäßigen Abständen nach außen in den Kantenbereich zu führen, die mit einem "Hauptband", das beabstandet von dem umzuformenden Kantenbereich angeordnet sein kann, verbunden sind. Die Laschen oder Verbreiterungen wären dabei aus einem Material gefertigt, das sich problemlos umformen lässt.

In Fig. 1 ist eine Variante skizziert, bei welcher die leitfähigen Bänder 4 auf der Oberseite, und zwar im nicht umzuformenden Bereich des bandförmigen Metallsubstrats (Flacherzeugnisses) 1 verlaufen. Die Lage der späteren Umformkanten ist in Fig. 1 durch strichpunktierte Linien 7 markiert, die parallel zur Durchlaufrichtung des bandförmigen Metallsubstrats 1 verlaufen.

Die Weiterverarbeitung der durch Querteilen des bandförmigen Metallsubstrats bzw. Flacherzeugnisses 1 erhaltenen Platinen zu Bauelementen kann auf bekannte Weise, vorzugsweise in einem kontinuierlichen Prozess erfolgen. Aus dem Flacherzeugnis 1 bzw. den Platinen werden beispielsweise durch Umformung oder Profilierung Dach- oder Fassadenelemente, Sichtschutz- und/oder Schallschutzwandelemente oder Garagentore hergestellt. Gemäß einer weiteren bevorzugten Variante kann das Querteilen auch nach der Weiterverarbeitung quasi als letzter Prozessschritt durchgeführt werden. Insbesondere können bei der Weiterverarbeitung des Flacherzeugnisses 1 bzw. der Platinen Anschlusselemente wie zum Beispiel Stecker, Dioden, Wechselrichter, etc. in die daraus hergestellten Bauelemente integriert werden. Des Weiteren können weitere Elemente, zum Beispiel elektronische Steuerungs- oder Regelungsvorrichtungen, Beleuchtungsstärke-Sensoren, etc., mit den Anschlusselementen kombiniert werden.

Aufgrund der im Wesentlichen durchgängig über die gesamte Länge des Bauelements ausgebildeten elektrisch leitfähigen Bänder (busbars) 4 kann der elektrische Kontaktabgriff am fertig konfektionierten Bauelement an beliebiger Stelle des jeweiligen elektrisch leitfähigen Bandes 4 erfolgen, und zwar jeweils einmal pro elektrisch leitfähigem Band 4, also zweimal pro Bauelement. Hierzu wird lokal und selektiv die elektrisch isolierende Abdeckschicht 5 entfernt, so dass das elektrisch leitfähige Band 4 in einem relativ kleinen, jedoch ausreichend großen Kontaktbereich freiliegt. In Fig. 5 sind mit 16 selektiv entfernte Bereiche bzw. Öffnungen der Abdeckschicht 5 bezeichnet. Das selektive Entfernen bzw. Abtragen der Abdeckschicht 5 erfolgt beispielsweise mittels eines Lasers oder mechanischen Fräswerkzeugs.

Die mit der Elektrode und der Gegenelektrode der organischen Solarzelle 3 verbundenen elektrisch leitfähigen Bänder 4 stellen den Plus- bzw. Minuspol der Solarzelle 3 dar. Sie werden mit geeigneten elektrischen Kontaktelementen abgegriffen. Die Kontaktelemente können dabei beispielsweise als Kontaktstecker, Kabelanschlussklemmen oder Kontaktschrauben ausgeführt sein. Zusätzlich können parallel verlaufende Kabel (nicht dargestellt), die an verschiedenen Stellen mit den Bändern 4 verbunden sind (z.B. durch vorbezeichnete Kontaktelemente), die Leitfähigkeit der einzelnen Bänder 4 erhöhen. Diese Kabel können beispielsweise bei Dach- oder Fassadenelementen im Stoßbereich der zu verbindenden Elemente angeordnet sein (hier nicht dargestellt).

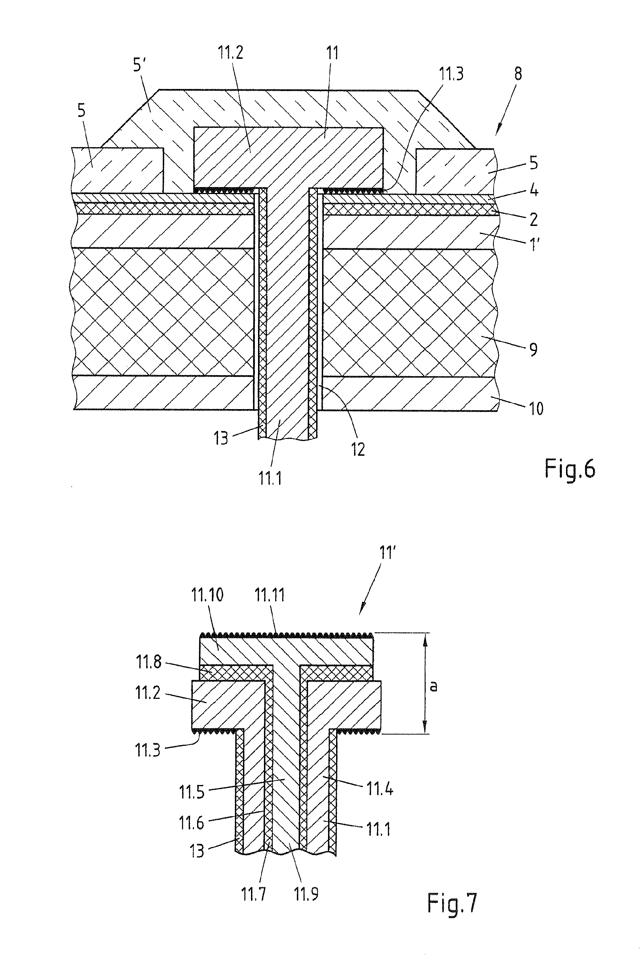

In Fig. 6 ist ein Abschnitt eines erfindungsgemäßen Bauelements 8 dargestellt. Das Bauelement 8 ist aus einer Platine 1' hergestellt, die durch Querteilen eines bandförmigen Metallsubstrats bzw. Flacherzeugnisses 1 gemäß Fig. 1 erhalten wurde. Um eines der elektrisch leitfähigen Bänder 4, die mit der Elektroden- bzw. Gegenelektrodenschicht (3.1, 3.3) der organischen Solarzelle 3 verbunden sind, elektrisch abgreifen zu können, wurde die elektrisch isolierende, transparente Abdeckschicht 5 selektiv abgetragen, insbesondere unter Sicherstellung der Barrierewirkung, und somit das elektrisch leitende Band 4 freigelegt.

Die durch Querteilen des bandförmigen Metallsubstrats bzw. Flacherzeugnisses 1 gemäß Fig. 1 erhaltene und vorzugsweise umgeformte oder profilierte Metallplatine 1' ist auf ihrer der Solarzelle 3 abgewandten Rückseite mit einer wärme- und/oder schallisolierenden Schicht 9 versehen. Die Schicht 9 ist beispielsweise aus Schaumstoff, insbesondere Polyurethan-Hartschaum, oder Mineralwolle gebildet und innenseitig mit einer Verkleidung (Innenschale) 10 kaschiert. Das Bauelement 8 hat in diesem Fall einen sandwichartigen Aufbau. Im Falle eines solchen Sandwich-Bauelements 8 werden die dem elektrischen Abgriff der elektrisch leitenden Bänder ("busbars") 4 dienenden Kontaktelement vorzugsweise durch das Sandwich-Bauelement 8 hindurchgeführt, so dass diese auf der Rückseite des Bauelements 8 mittels geeigneter Kabel oder dergleichen abgegriffen werden können.

In dem in Fig. 6 dargestellten Ausführungsbeispiel sind die elektrischen Kontaktelemente 11 als Kontaktschrauben ausgeführt, wobei der Einfachheit halber nur eine einzelne Kontaktschraube 11 gezeigt ist. Im Bereich der freigelegten elektrisch leitenden Bänder 4 sind Durchgangslöcher 12 in das Bauelement 8 gestanzt oder gebohrt, die sich von dem jeweiligen Band 4 bis zur Rückseite des Bauelements 8 erstrecken. In diese Löcher 12 sind die Kontaktschrauben 11 eingesetzt, wobei der Schaft 11.1 der jeweiligen Kontaktschraube 11 mit einer elektrisch isolierenden Hülse 13, einem entsprechenden Isolierschlauch oder dergleichen versehen ist. Der Kontaktschraubenkopf 11.2 weist an seiner Unterseite vorzugsweise eine raue Kontaktfläche 11.3 auf, die beispielsweise eine gezahnte Struktur besitzt. Durch eine derart ausgebildete Kontaktfläche 11.3 ergibt sich ein besonders zuverlässiger elektrischer Kontaktabgriff. Die Kontaktschraube 11 kann unter Verwendung von elektrisch isolierenden Kunststoff-Unterlegscheiben (nicht gezeigt) und/oder elektrisch isolierenden Kunststoff-Muttern (nicht gezeigt) an der der Innenschale 10 des Bauelements 8 befestigt werden. Die zuvor an der Vorderseite des Bauelements 8 freigelegte Kontaktstelle wird nach der Montage des Kontaktelements bzw. der Kontaktschraube 11 mit einem geeigneten Material, beispielsweise einer elektrisch isolierenden, aushärtenden Dichtmasse 5' und/oder einer Kunststoffkappe (nicht gezeigt) versiegelt.

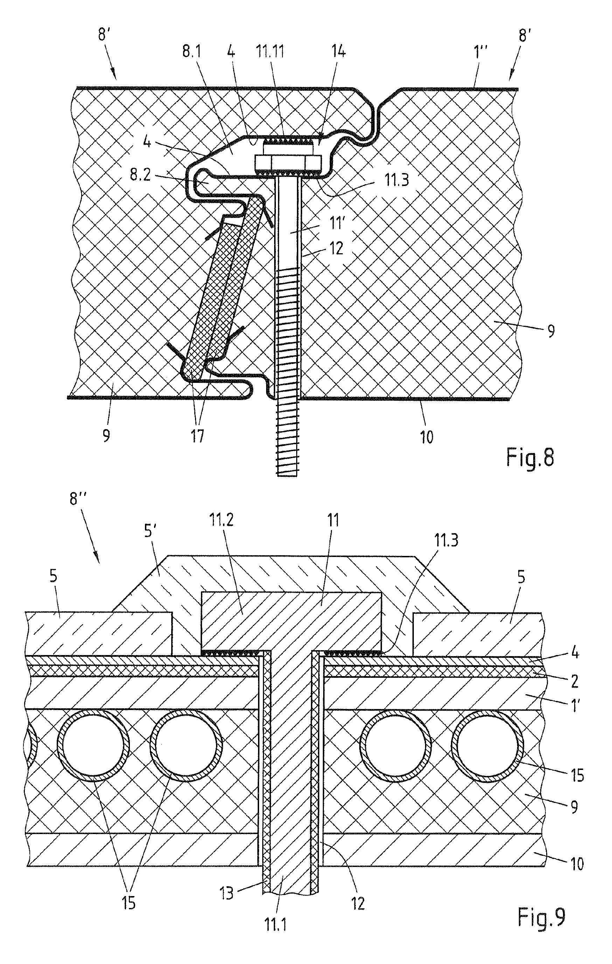

In Fig. 8 sind miteinander verbundene Abschnitte zweier metallischer Bauelemente 8' dargestellt, die auf ihrer Sichtseite (Außenseite) jeweils mit mindestens einer organischen Solarzelle (3) versehen sind. Die Bauelemente 8' sind sandwichartig aufgebaut. Sie weisen eine metallische Innenschale 10, eine metallische Außenschale 1" und eine dazwischen angeordnete Kernschicht 9 aus Hartschaumstoff oder Mineralfasern auf. Die Ränder der Außenschale 1" sowie der Innenschale 10 sind profiliert bzw. mehrfach abgekantet. Die Außenschale 1" und die Innenschale 10 sind durch oder über die Kernschicht 9 miteinander verbunden. Beispielsweise werden die Außenschale 1" und die Innenschale 10 mit einem zu Hartschaum aushärtenden Polyurethan-Schaumstoff-Gemisch hinterschäumt, wobei die stoffschlüssige Verbindung zwischen Schaumstoff und metallischer Schale durch den Formschluss im Bereich der Kantenprofile der metallischen Schalenränder zusätzlich unterstützt bzw. erhöht wird. Mit 17 sind die Außenschale 1" und die Innenschale 10 verbindende Dichtungsstreifen bezeichnet.

Außenschale 1" und Innenschale 10 eines Bauelements 8' gemäß Fig. 8 können durch Umformen von Platinen hergestellt werden, die durch Querteilen eines bandförmigen Metallsubstrats 1 bzw. Flacherzeugnisses gemäß Fig. 1 erhalten wurden. Die Platine wird hierzu derart umgeformt, dass eine Längskante der umgeformten Platine eine Längsnut 8.1 und die gegenüberliegende Längskante der umgeformten Platine eine in die Längsnut 8.1 einer entsprechend umgeformten Platine einsteckbare Feder 8.2 bildet. Das Metallsubstrat 1 bzw. die Platine wird insbesondere so umgeformt, dass sich danach das eine elektrisch leitfähige Band 4 in der Längsnut 8.1, abgewandt von der solarzellenbeschichteten Oberseite der Platine (Außenschale 1") und das andere elektrisch leitfähige Band 4 auf der Oberseite der der Längsnut 8.1 zugeordneten Feder 8.2 der Außenschale 1" befindet.

Vorzugsweise ist die obere leitfähige Schicht (Elektrode oder Gegenelektrode) 3.3 der organischen Solarzelle 3 soweit bis zum Rand des Metallsubstrats (metallischen Flacherzeugnisses) 1 positioniert, dass sie nach der Umformung zu einem Bauelement bzw. zu einer Außenschale 1" des Bauelements 8' auf dessen Rückseite liegt. Die elektrische Kontaktierung kann somit an dieser Stelle so ausgeführt werden, dass sie nach Abschluss der Montage- und Kontaktierungsarbeiten von außen unsichtbar ist (vgl. Fig. 8). Zusätzlich ist die Kontaktstelle 14 bei dieser Ausführungsform vor einem Angriff durch äußere Einflüsse geschützt.

Zum elektrischen Abgriff der elektrisch leitfähigen Schichten 3.1, 3.3 bzw. elektrisch leitenden Bänder 4 werden im Bereich der Feder 8.2 des Bauelements 8' eine oder mehrere Durchgangsöffnungen 12 hergestellt, z.B. gebohrt, durch die Kabel und/oder elektrische Kontaktelemente 11' für den Plus- und Minuspol der organischen Solarzelle (3) hindurchgeführt bzw. eingesteckt werden können. Bei der Bohrung sollte sicher gestellt sein, dass die Barrierewirkung nicht beeinflusst wird.

Bei dem in Fig. 8 dargestellten Ausführungsbeispiel werden schraubenförmige Kontaktelemente 11' zum elektrischen Abgriff der elektrisch leitfähigen Schichten 3.1, 3.3 der Solarzellen bzw. elektrisch leitenden Bänder 4 verwendet, wobei das jeweilige schraubenförmige Kontaktelement 11' mindestens zwei elektrische Leiter 11.4, 11.5 umfasst, die koaxial zueinander verlaufende Abschnitte aufweisen und voneinander elektrisch isoliert sind (siehe Fig. 7).

In Fig. 7 ist die Ausführung des Kopfbereichs eines solchen Kontaktelements 11' detaillierter skizziert. Das Kontaktelement 11' ist aus mehreren Teilen zusammengesetzt. Es umfasst ein erstes schraubenförmiges Kontaktteil 11.4 mit einer axialen Durchgangsbohrung 11.6, die sich durch den durchmessererweiterten Kopf 11.2 und den sich daran einstückig anschließenden Schaft 11.1 erstreckt. Kopf 11.2 und Schaft 11.1 sind aus elektrisch leitfähigem Material hergestellt und definieren somit einen ersten elektrischen Leiter 11.4. Der Kontaktschraubenkopf 11.2 weist dabei an seiner Unterseite vorzugsweise eine raue Kontaktfläche 11.3 auf, die beispielsweise eine gezahnte Struktur besitzt. Der Hohlschaft 11.1 ist wiederum mit einem elektrischen Isolator 13 ummantelt. In die axiale Durchgangsbohrung 11.6 ist eine rohrförmige Hülse 11.7 eingesetzt, die an beiden Enden offen ist und an einem ihrer Enden einen Flansch 11.8 aufweist. Die Hülse 11.7 und der Flansch 11.8 bestehen aus elektrisch isolierendem Material und sind vorzugsweise einstückig ausgebildet.

In der Hülse 11.7 ist ein zweites Kontaktteil 11.5 aufgenommen, das wiederum einen Schaft 11.9 und einen durchmessererweiterten Kopf 11.10 aufweist. Schaft 11.9 und Kopf 11.10 bestehen aus elektrisch leitendem Material. Das erste Kontaktteil 11.4 und das zweite Kontaktteil 11.5 definieren axial beanstandete Kontaktflächen 11.3, 11.11. Vorzugsweise ist auch die Kontaktfläche 11.11 des zweiten Kontaktteils 11.5 rau ausgebildet, beispielsweise mit einer gezahnten Struktur versehen.

Ferner können die Kontaktteile 11.4, 11.5 relativ zueinander verstellt, beispielsweise verschoben oder schraubenartig verdreht werden, so dass der Abstand a zwischen den Kontaktflächen 1.3, 11.11 variabel ist.

Des Weiteren liegt es auch im Rahmen der Erfindung, die Hülse 11.7 und den Flansch 11.8 als separate Teile herzustellen und die Hülse 11.7 mit einem Außengewinde und den ringförmigen Flansch 11.8 mit einem entsprechenden Innengewinde zu versehen, so dass die Lage des Flansches 11.8 in Bezug auf das Ende der Hülse 11.7 durch Drehen des Flansches 11.8 justiert werden kann.

Das in Fig. 7 bzw. Fig. 8 dargestellte Kontaktelement 11' bietet den Vorteil, dass es lediglich eine einzige Durchgangsöffnung 12 im Bauelement 8' erfordert, um zwei Elektrodenschichten (3.1, 3.3) einer organischen Solarzelle bzw. daran angeschlossene elektrisch leitende Bänder 4 des Bauelements 8' abzugreifen.

Das in Fig. 9 skizzierte Bauelement 8" unterscheidet sich von dem in Fig. 6 gezeigten Ausführungsbeispiel dadurch, dass in dem Bauelement zusätzlich mindestens eine Rohrleitung 15 eines Solarthermie-Kollektors integriert sind. Die Rohrleitung 15 bzw. der Solarthermie-Kollektor sind auf der Rückseite des Metallsubstrats 1' angeordnet. Durch die Rohrleitung 15 wird ein Wärmeträgermedium geleitet, das durch die Solarstrahlung erwärmt und im Kreislauf zu einem Wärmetauscher geleitet wird. Das Bauelement 8" gemäß Fig. 9 kann somit gleichzeitig elektrischen Strom und Wärmeenergie liefern.

Als weitere Option kann das Bauelement 8, 8', 8" gemäß Fig. 6, 8 und/oder 9 mit einer thermochromen Beschichtung versehen sein. Bei unterschiedlichen Temperaturen erscheint das Bauelement 8, 8' oder 8" dann in unterschiedlichen Farben. Damit können gestalterische Effekte in einer aus entsprechenden Bauelementen 8, 8' oder 8" gebildeten Fassade erzielt werden.

Die Ausführung der vorliegenden Erfindung ist nicht auf die vorstehend beschriebenen Ausführungsbeispiele beschränkt. Vielmehr sind eine Vielzahl von Varianten denkbar, die auch bei einer von den dargestellten Ausführungsbeispielen abweichenden Gestaltung von der in den anliegenden Ansprüchen angegebenen Erfindung Gebrauch machen. Insbesondere liegt es im Rahmen der Erfindung, einzelne oder mehrere Merkmale der vorstehend beschriebenen Ausführungsbeispiele miteinander zu kombinieren.

## Patentansprüche

1. Verfahren zur Herstellung eines metallischen Flacherzeugnisses oder Bauelements (8, 8', 8") mit photovoltaisch wirksamer Beschichtung, bei dem auf ein bandförmiges Metallsubstrat (1), vorzugsweise Stahlsubstrat, das mindestens einseitig mit einer mindestens teilweise elektrisch isolierenden Schicht (2) versehen ist, in kontinuierlichem Durchlauf auf die mindestens teilweise elektrisch isolierende Schicht (2) bereichsweise elektrisch leitfähige Schichten (3.1, 3.3) als Elektrode und Gegenelektrode mit mindestens einer dazwischen angeordneten photoaktiven Polymerschicht (3.2) zur Bildung organischer Solarzellen (3) so aufgebracht werden, dass die Solarzellen (3) in Längsrichtung des bandförmigen Metallsubstrats (1) aufeinanderfolgend angeordnet sind, wobei in Durchlaufrichtung des bandförmigen Metallsubstrates (1) elektrisch leitfähige Bänder (4) parallel zueinander verlaufend so aufgebracht werden, dass eines der Bänder (4) die Elektrode der Solarzellen (3) und ein anderes der Bänder (4) die Gegenelektrode der Solarzellen (3) miteinander elektrisch verbindet, wobei die elektrisch leitfähigen Bänder (4) an gegenüberliegenden Rändern der Solarzellen (3) so angeordnet werden, dass mindestens eines der elektrisch leitfähigen Bänder (4) die Elektrode oder Gegenelektrode der Solarzellen (3) in Richtung Längskante des bandförmigen Metallsubstrats (1) überragt oder bündig mit der Elektrode oder Gegenelektrode der Solarzellen (3) abschließt, und wobei eine durch Querteilen des bandförmigen Metallsubstrats (1) erhaltene Platine (1') so umgeformt wird, dass dadurch mindestens eines der elektrisch leitfähigen Bänder (4) rückseitig zu der solarzellenbeschichteten Oberseite angeordnet wird.

2. Verfahren nach Anspruch 1, **dadurch gekennzeichnet, dass** das bandförmige Metallsubstrat (1) zwischen zwei der aufeinander folgenden organischen Solarzellen (3) quergeteilt wird.

3. Verfahren nach Anspruch 1 oder 2, **dadurch gekennzeichnet, dass** eine durch Querteilen des bandförmigen Metallsubstrats (1) erhaltene Platine so umgeformt wird, dass eine Längskante der Platine eine Längsnut (8.1) und die gegenüberliegende Längskante der Platine eine in die Längsnut (8.1) einer entsprechend umgeformten Platine (1', 1") einsteckbare Feder (8.2) bildet, und dass dadurch das eine elektrisch leitfähige Band (4) in der Längsnut (8.1), abgewandt von der solarzellenbeschichteten Oberseite der Platine (1', 1") angeordnet wird, während das andere elektrisch leitfähige Band (4) auf der Oberseite der Feder (8.2) angeordnet wird.

4. Verfahren nach einem der Ansprüche 1 bis 3, **dadurch gekennzeichnet, dass** die auf das bandförmige Metallsubstrat (1, 1') aufgebrachten Solarzellen (3) sowie die aufgebrachten elektrisch leitfähigen Bänder (4) mit einer elektrisch isolierenden, transparenten Abdeckschicht (5) versehen werden.

5. Verfahren nach Anspruch 4, **dadurch gekennzeichnet, dass** die Abdeckschicht (5) im Bereich der elektrisch leitfähigen Bänder (4) partiell abgetragen wird.

6. Verfahren nach einem der Ansprüche 1 bis 5, **dadurch gekennzeichnet, dass** im Bereich mindestens eines der elektrisch leitfähigen Bänder (4) mindestens eine Durchgangsöffnung (12) in das Metallsubstrat (1, 1', 1") eingearbeitet wird.

7. Verfahren nach einem der Ansprüche 1 bis 6, **dadurch gekennzeichnet, dass** aus dem bandförmigen Metallsubstrat (1) durch Querteilen desselben erhaltene Platinen (1', 1") auf ihrer der jeweiligen Solarzelle (3) abgewandten Rückseite jeweils mit einer wärme- und/oder schallisolierenden Schicht (9) kaschiert oder geschäumt werden.

8. Verfahren nach einem der Ansprüche 1 bis 7, **dadurch gekennzeichnet, dass** aus dem bandförmigen Metallsubstrat (1) durch Querteilen desselben erhaltene Platinen (1') auf ihrer der jeweiligen Solarzelle (3) abgewandten Rückseite jeweils mit einem Solarthermie-Kollektor (15) versehen werden.

9. Verfahren nach einem der Ansprüche 1 bis 8, **dadurch gekennzeichnet, dass** als elektrisch isolierende Schicht (2) des bandförmigen Metallsubstrats (1) und/oder als elektrisch isolierende, transparente Abdeckschicht (5) eine thermochrome Beschichtung verwendet wird.

10. Verfahren nach einem der Ansprüche 1 bis 9, **dadurch gekennzeichnet, dass** das bandförmige Metallsubstrat (1) nach Aufbringen der organischen Solarzellen (3), der elektrisch leitfähigen Bänder (4) und einer elektrisch isolierenden, transparenten Abdeckschicht (5) zu einer Rolle aufgewickelt wird.

11. Verfahren nach einem der Ansprüche 1 bis 9, **dadurch gekennzeichnet, dass** das bandförmige Metallsubstrat (1) nach Aufbringen der organischen Solarzellen (3), der elektrisch leitfähigen Bänder (4) und einer elektrisch isolierenden, transparenten Abdeckschicht (5) durch Rollformen umgeformt wird.

12. Metallisches Bauelement (8') mit einer photovoltaisch wirksamen Beschichtung, umfassend mindestens eine organische Solarzelle (3) und ein Metallsubstrat (1), vorzugsweise Stahlsubstrat, das mindestens einseitig mit einer mindestens teilweise elektrisch isolierenden Schicht (2) versehen ist, auf die bereichsweise elektrisch leitfähige Schichten (3.1, 3.3) als Elektrode und Gegenelektrode mit mindestens einer dazwischen angeordneten photoaktiven Polymerschicht (3.2) zur Bildung der mindestens einen organischen Solarzelle (3) aufgebracht sind, wobei auf die elektrisch isolierende Schicht (2) elektrisch leitfähige Bänder (4) parallel zueinander verlaufend so aufgebracht sind, dass eines der Bänder (4) die Elektrode der Solarzelle (3) und ein anderes der Bänder (4) die Gegenelektrode der Solarzelle (3) elektrisch kontaktiert, wobei die elektrisch leitfähigen Bänder (4) an gegenüberliegenden Rändern der Solarzelle (3) so angeordnet sind, dass mindestens eines der elektrisch leitfähigen Bänder (4) die Elektrode oder Gegenelektrode der Solarzelle (3) seitlich überragt oder bündig mit der Elektrode oder Gegenelektrode der Solarzelle (3) abschließt, und wobei das Metallsubstrat (1) so umgeformt ist, dass mindestens eines der elektrisch leitfähigen Bänder (4) rückseitig zu der solarzellenbeschichteten Oberseite angeordnet ist.

13. Bauelement (8') nach Anspruch 12, **dadurch gekennzeichnet, dass** es als Dach- oder Fassadenelement, Sichtschutz- und/oder Schallschutzwandelement oder Garagentor ausgebildet ist.

14. Verkleidung zusammengesetzt aus mehreren Bauelementen (8') gemäß Anspruch 12 oder 13, wobei die elektrisch leitfähigen Bänder (4) mit elektrischen Kontaktelementen (11') versehen sind, die einen elektrischen Abgriff auf der Rückseite der Verkleidung gestatten.

15. Verkleidung nach Anspruch 14, **dadurch gekennzeichnet, dass** die elektrischen Kontaktelementen (11') als Kontaktschrauben oder Kontaktstecker ausgeführt sind.

16. Verkleidung nach Anspruch 14 oder 15, **dadurch gekennzeichnet, dass** das jeweilige elektrische Kontaktelement (11') mindestens zwei elektrische Leiter (11.4, 11.5) umfasst, die koaxial zueinander verlaufende Abschnitte aufweisen und voneinander elektrisch isoliert sind.

17. Verkleidung nach Anspruch 16, **dadurch gekennzeichnet, dass** die elektrischen Leiter (11.4, 11.5) einander abgewandte Kontaktflächen (11.3, 11.11) definieren und relativ zueinander verstellbar sind, so dass der Abstand (a) zwischen den Kontaktflächen (11.3, 11.11) variabel ist.
